# EUROPEAN PATENT SPECIFICATION

(11) **EP 3 537 606 B1**
(45) Date of publication and mention of the grant of the patent: **04.05.2022**
(21) Application number: 18160930.6
(22) Date of filing: 09.03.2018
(51) Int. Cl.: H03K 17/955

(54) **CIRCUIT FOR A CAPACITIVE PROXIMITY SWITCH, PROXIMITY SWITCH AND HOUSEHOLD APPLIANCE**
SCHALTUNG FÜR EINEN KAPAZITIVEN NÄHERUNGSSCHALTER, NÄHERUNGSSCHALTER UND HAUSHALTSGERÄT
CIRCUIT POUR COMMUTATEUR DE PROXIMITÉ CAPACITIF, COMMUTATEUR DE PROXIMITÉ ET APPAREIL MÉNAGER

(43) Date of publication of application: 11.09.2019
(73) Proprietor: E.G.O. Elektro-Gerätebau GmbH, 75038 Oberderdingen (DE)
(72) Inventor: Knappe, Gerd, 75015 Bretten (DE); Manan, Jose Antonio, 08110 Montcada i Reixac (ES)
(74) Representative: Patentanwälte Ruff, Wilhelm, Beier, Dauster & Partner mbB

(56) References cited:
- US-A- 4 796 013

## Description

### Field of application and prior art

The invention relates to a circuit for a capacitive proximity switch, to a proximity switch comprising such a circuit and to a household appliance comprising such a proximity switch.

Capacitive proximity switches may be used in different applications in order to sense user inputs. For example, a user may use his finger in order to control a household appliance like a washing machine or a refrigerator. One such household appliance in the form of a cooking field having such capacitive proximity switches is known from EP 859467 A1.

Known capacitive proximity switches usually have a low output signal distance and thus require expensive analog-digital-converters (ADC) in order to be read out.

From US 4,796,013 B1 a capacitive proximity switch or detector apparatus, respectively, is known having first and second electrodes to define an electric field there between. The purpose is to detect whether a person is present between these two electrodes. The detector apparatus has a detector circuit being able to detect a change in a capacitor formed between the two electrodes. This detector circuit is provided with several diodes, an oscillator, a resistor and a couple of capacitors.

### Object and solution

It is thus an object of the present invention to provide for an alternative or optimized circuit for a capacitive proximity switch. It is a further object of the present invention to provide for a proximity switch comprising such a circuit. It is a further object of the present invention to provide for a household appliance comprising such a capacitive proximity switch.

This is solved by a circuit with the features of claim 1, a proximity switch with the features of claim 10, and a household appliance with the features of claim 12. Advantageous and preferred embodiments of the invention are the subject of the further claims and will be explained in more detail in the following. Some of the technical features will be described only for the circuit or only for the proximity switch or only for the household appliance. However, the scope of protection is defined by the appended claims.

The invention relates to a circuit for a capacitive proximity switch. The circuit comprises a common mass. The circuit also comprises a voltage source configured to deliver an alternating signal. The voltage source has a first pole and a second pole. The first pole of the voltage source is connected to the common mass.

The circuit further comprises a first diode having an anode and a cathode. The anode of the first diode is connected to the second pole of the voltage source.

The circuit also comprises a measuring capacitor having a first electrode and a second electrode. The first electrode of the measuring capacitor is connected to the common mass. The second electrode of the measuring capacitor is connected to the cathode of the first diode.

The circuit further comprises an impedance converter having a first pole and a second pole. The first pole of the impedance converter is connected to the cathode of the first diode.

The circuit comprises a second diode having an anode and a cathode. The anode of the second diode is connected to the second pole of the impedance converter.

The circuit further comprises an output capacitor having a first electrode and a second electrode. The first electrode of the output capacitor is connected to the common mass. The second electrode of the output capacitor is connected to the cathode of the second diode. The output capacitor provides an output signal of the circuit.

According to the invention, the impedance converter is a pnp-transistor, in particular a bipolar pnp-transistor, an emitter of the pnp-Transistor forming the first pole of the impedance converter. A collector of the pnp-Transistor forms the second pole of the impedance converter. Such a pnp-Transistor has proven as being a suitable impedance converter for the intended purpose.

The circuit according to the invention provides for a significantly increased output signal distance and thus allows omitting an analog-digital-converter for readout. This may save costs in appliances that should be controlled using a proximity switch.

Preferably, a base of the pnp-Transistor is connected, via a first resistor, to the second pole of the voltage source. Such a configuration has proven to provide for a good signal distance.

Preferably, the first resistor has a resistance between 0.3 MOhm and 2.5 MOhm, further preferably between 0.5 MOhm and 1.5 MOhm, for example 1 MOhm. Such values have been proven suitable in practice.

Preferably, the alternating signal is a square wave signal.

Preferably, the alternating signal alternates with a frequency between 5 kHz and 80 kHz, preferably between 10 kHz and 40 kHz.

According to a preferred implementation, the measuring capacitor is configured to vary its capacity depending on a distance or proximity of a nearby object, in particular a finger of a user. This allows identification of user action.

According to another implementation, the circuit further comprises a second resistor being connected between the common mass and the cathode of the first diode. This allows for a controlled discharge of the measuring capacitor and for a setting of an operation point.

Preferably, the second resistor has a resistance between 2.5 MOhm and 6.9 MOhm, further preferably between 4.0 MOhm and 5.4 MOhm, for example about 4.7 MOhm. Such values have been proven suitable in practice.

According to a preferred implementation, the circuit further comprises a third resistor being connected parallel to the output capacitor. This allows a controlled discharge of the output capacitor.

Preferably, the third resistor has a resistance between 250 kOhm and 800 kOhm, further preferably between 400 kOhm and 540 kOhm, for example about 470 kOhm. Such values have been proven suitable in practice.

According to a preferred implementation, the circuit comprises a Schmitt-Trigger-circuit being connected to sense the output signal and delivering a digital or logic level output signal. This allows for an integrated production of a digital or logic level output signal that can immediately be further processes in digital electronics of any kind.

In typical implementations, the circuit according to the invention may reach a signal distance between 80 % and 90 %, which is far better than signal distances of about 20 % reached by circuits known from the prior art.

In addition, the circuit described before has been proven to be robust against EMC and HF disturbances.

The invention relates further to a proximity switch comprising a circuit according to the invention. With regard to the circuit, all embodiments and variations disclosed herein may be applied.

According to a preferred implementation of the capacitive proximity switch, the circuit itself is without a Schmitt-Trigger-circuit or does not have such a Schmitt-Trigger. The proximity switch further comprises a controller having a Schmitt-Trigger-capable input being connected with the output capacitor of the circuit. Thus, a Schmitt-Trigger functionality that is present in the controller anyway can be used in order to read out the circuit or its signals, respectively.

The invention further relates to a household appliance, in particular a washing machine or a refrigerator, comprising a proximity switch according to the invention as described before. With regard to the proximity switch, all embodiments and variations disclosed herein can be applied. In the context of a refrigerator, it is for example possible to set the desired temperature using the proximity switch, for example with a plus switch and a minus switch. In the context of a washing machine, it is for example possible to set a washing program using the proximity switch. Both is known in the art.

### Brief description of the drawing

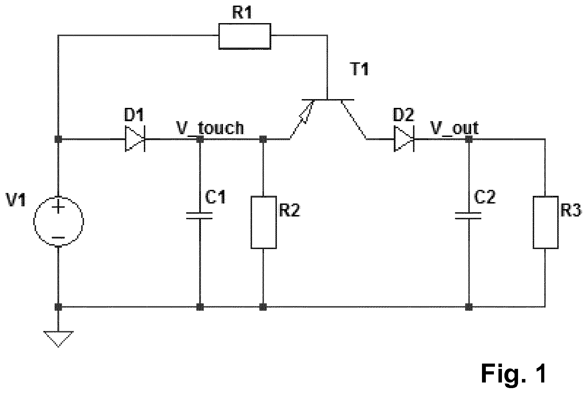

Further advantages and details will be apparent from the following description of an embodiment, which is given with reference to figure 1. Figure 1 shows a circuit for a proximity switch according to an embodiment of the invention.

### Detailed description of the exemplary embodiment

The circuit comprises a voltage source V1 having a first pole (denoted -) and a second pole (denoted +). The first pole of the voltage source V1 is connected to a common mass.

The circuit comprises a first diode D1 having an anode and a cathode. The anode of the first diode D1 is connected to the second pole of the voltage source V1.

The circuit comprises a measuring capacitor C1 having a first electrode and a second electrode.

The first electrode of the measuring capacitor C1 is connected to the common mass. The second electrode of the measuring capacitor C1 is connected to the cathode of the first diode D1 and exhibits a potential named V_touch.

The measuring capacitor C1 is configured to change its capacitance depending on proximity of an object that is not shown in figure 1. For example, such an object may be a stylus or a finger of a user.

The circuit comprises an impedance converter in the form of a bipolar pnp-transistor T1. The transistor T1 comprises an emitter that is connected to the cathode of the first diode D1 and thus lies on the potential V_touch. The transistor T1 comprises a base that is connected to the second pole of the voltage source V1, via a first resistor R1. This defines the voltage level of the base of the transistor R1. The transistor further comprises a collector. The transistor T1 is acting as switch and impedance converter to bring the square wave V_touch to the collector side of the transistor T1.

In parallel to the measuring capacitor C1, there is connected a second resistor R2. The second resistor R2 defines an operating point and damps a signal.

The circuit comprises a second diode D2 having an anode and a cathode. The anode of the second diode D2 is connected to the collector of the transistor T1.

The circuit comprises an output capacitor C2 having a first electrode being connected to the common mass, and a second electrode being connected to the cathode of the second diode D2. The second electrode of the output capacitor C2 exhibits an output signal V_out.

In parallel to the output capacitor C2, there is connected a third resistor R3 to unload the output capacitor C2.

The second diode D2 and the output capacitor C2 work to rectify and smooth the signal obtained from the collector of the transistor T1.

Example values for the components that have been proven suitable are as follows:
C2 = 10 nF
R1 = 1 MOhm
R2 = 4.7 MOhm
R3 = 470 kOhm

The voltage source V1 may deliver a square wave signal having a frequency between 10 kHz and 40 kHz. For C1 no fixed capacitance can be given because the capacitance is variable. Typically, the measuring capacitor C1 is implemented as a capacitive touch sensor, for example according to EP 859467 A1 mentioned at the beginning.

Typical types of components are as follows:
D1 = BAS19
D2 = BAS19
T1 = BC857B

The output signal V_out can be read out digitally, as it exhibits - for example with the exemplary implementation given herein - a typical signal distance of about 80 % to 90 %.

## Claims

1. Circuit for a capacitive proximity switch, the circuit comprising
- a common mass,
- a voltage source (V1) configured to deliver an alternating signal, having a first pole and a second pole, the first pole of the voltage source (V1) being connected to the common mass,
- a first diode (D1) having an anode and a cathode, the anode of the first diode (D1) being connected to the second pole of the voltage source (V1),
- a measuring capacitor (C1) having a first electrode and a second electrode, the first electrode of the measuring capacitor (C1) being connected to the common mass, the second electrode of the measuring capacitor (C1) being connected to the cathode of the first diode (D1),
- an impedance converter having a first pole and a second pole, the first pole of the impedance converter being connected to the cathode of the first diode (D1),
- a second diode (D2) having an anode and a cathode, the anode of the second diode (D2) being connected to the second pole of the impedance converter,
- an output capacitor (C2) having a first electrode and a second electrode, the first electrode of the output capacitor (C2) being connected to the common mass, the second electrode of the output capacitor (C2) being connected to the cathode of the second diode (D2), the output capacitor (C2) providing an output signal of the circuit,
**characterized in that** the impedance converter is a pnp-Transistor (T1), an emitter of the pnp-Transistor (T1) forming the first pole of the impedance converter, a collector of the pnp-Transistor forming the second pole of the impedance converter.

2. Circuit according to claim 1, wherein a base of the pnp-Transistor (T1) is connected, via a first resistor (R1), to the second pole of the voltage source (V1).

3. Circuit according to claim 2, wherein the first resistor (R1) has a resistance between 0.5 MOhm and 1.5 MOhm, in particular 1 MOhm.

4. Circuit according to one of the preceding claims, wherein the alternating signal is a square wave signal.

5. Circuit according to one of the preceding claims, wherein the alternating signal alternates with a frequency between 10 kHz and 40 kHz.

6. Circuit according to one of the preceding claims, wherein the measuring capacitor (C1) is configured to vary its capacity depending on a distance or proximity of a nearby object, in particular a finger of a user.

7. Circuit according to one of the preceding claims, further comprising a second resistor (R2) being connected between the common mass and the cathode of the first diode (D1), wherein the second resistor (R2) has a resistance between 4.0 MOhm and 5.4 MOhm, preferably 4.7 MOhm.

8. Circuit according to one of the preceding claims, further comprising a third resistor (R3) being connected parallel to the output capacitor (C2), wherein the third resistor (R3) has a resistance between 400 kOhm and 540 kOhm, preferably 470 kOhm.

9. Circuit according to one of the preceding claims, further comprising a Schmitt-Trigger-circuit being connected to sense the output signal and delivering a binary output signal.

10. Proximity switch comprising a circuit according to one of the preceding claims.

11. Proximity switch according to claim 10, wherein the circuit is without a Schmitt-Trigger-circuit, the proximity switch further comprising a controller having a Schmitt-Trigger-capable input being connected with the output capacitor (C2) of the circuit.

12. Household appliance, in particular washing machine or refrigerator, comprising a proximity switch according to one of claims 10 or 11.

## Patentansprüche

1. Schaltung für einen kapazitiven Näherungsschalter, wobei die Schaltung Folgendes umfasst:
- eine gemeinsame Masse,
- eine Spannungsquelle (V1), die so konfiguriert ist, dass sie ein Wechselsignal liefert, mit einem ersten Pol und einem zweiten Pol, wobei der erste Pol der Spannungsquelle (V1) mit der gemeinsamen Masse verbunden ist,
- eine erste Diode (D1) mit einer Anode und einer Kathode, wobei die Anode der ersten Diode (D1) mit dem zweiten Pol der Spannungsquelle (V1) verbunden ist,
- einen Messkondensator (C1) mit einer ersten Elektrode und einer zweiten Elektrode, wobei die erste Elektrode des Messkondensators (C1) mit der gemeinsamen Masse verbunden ist und die zweite Elektrode des Messkondensators (C1) mit der Kathode der ersten Diode (D1) verbunden ist,
- einen Impedanzwandler mit einem ersten Pol und einem zweiten Pol, wobei der erste Pol des Impedanzwandlers mit der Kathode der ersten Diode (D1) verbunden ist,
- eine zweite Diode (D2) mit einer Anode und einer Kathode, wobei die Anode der zweiten Diode (D2) mit dem zweiten Pol des Impedanzwandlers verbunden ist,
- einen Ausgangskondensator (C2) mit einer ersten Elektrode und einer zweiten Elektrode, wobei die erste Elektrode des Ausgangskondensators (C2) mit der gemeinsamen Masse verbunden ist, wobei die zweite Elektrode des Ausgangskondensators (C2) mit der Kathode der zweiten Diode (D2) verbunden ist und der Ausgangskondensator (C2) ein Ausgangssignal der Schaltung liefert,
**dadurch gekennzeichnet, dass** der Impedanzwandler ein pnp-Transistor (T1) ist, wobei ein Emitter des pnp-Transistors (T1) den ersten Pol des Impedanzwandlers bildet und ein Kollektor des pnp-Transistors den zweiten Pol des Impedanzwandlers bildet.

2. Schaltung nach Anspruch 1, wobei eine Basis des pnp-Transistors (T1) über einen ersten Widerstand (R1) mit dem zweiten Pol der Spannungsquelle (V1) verbunden ist.

3. Schaltung nach Anspruch 2, wobei der erste Widerstand (R1) einen Widerstand zwischen 0,5 MOhm und 1,5 MOhm, insbesondere 1 MOhm, aufweist.

4. Schaltung nach einem der vorhergehenden Ansprüche, wobei das Wechselsignal ein Rechtecksignal ist.

5. Schaltung nach einem der vorhergehenden Ansprüche, wobei das Wechselsignal mit einer Frequenz zwischen 10 kHz und 40 kHz wechselt.

6. Schaltung nach einem der vorhergehenden Ansprüche, wobei der Messkondensator (C1) so konfiguriert ist, dass er seine Kapazität in Abhängigkeit von einem Abstand oder der Nähe eines nahen Objekts, insbesondere eines Fingers eines Benutzers, verändert.

7. Schaltung nach einem der vorhergehenden Ansprüche, die ferner einen zweiten Widerstand (R2) umfasst, der zwischen der gemeinsamen Masse und der Kathode der ersten Diode (D1) verbunden ist, wobei der zweite Widerstand (R2) einen Widerstand zwischen 4,0 MOhm und 5,4 MOhm, vorzugsweise 4,7 MOhm, aufweist.

8. Schaltung nach einem der vorhergehenden Ansprüche, die ferner einen dritten Widerstand (R3) umfasst, der parallel zu dem Ausgangskondensator (C2) verbunden ist, wobei der dritte Widerstand (R3) einen Widerstand zwischen 400 kOhm und 540 kOhm, vorzugsweise 470 kOhm, aufweist.

9. Schaltung nach einem der vorhergehenden Ansprüche, die ferner eine Schmitt-TriggerSchaltung umfasst, die zum Empfangen des Ausgangssignals verbunden ist und ein binäres Ausgangssignal liefert.

10. Näherungsschalter mit einer Schaltung nach einem der vorhergehenden Ansprüche.

11. Näherungsschalter nach Anspruch 10, wobei die Schaltung ohne Schmitt-TriggerSchaltung ist, wobei der Näherungsschalter ferner eine Steuerung mit einem Schmitt-Trigger-fähigen Eingang umfasst, der mit dem Ausgangskondensator (C2) der Schaltung verbunden ist.

12. Haushaltsgerät, insbesondere eine Waschmaschine oder ein Kühlschrank, das einen Näherungsschalter nach einem der Ansprüche 10 oder 11 umfasst.

## Revendications

1. Circuit pour commutateur de proximité capacitif, le circuit comprenant
- une masse commune,
- une source de tension (V1) conçue pour délivrer un signal alternatif, ayant un premier pôle et un second pôle, le premier pôle de la source de tension (V1) étant raccordé à la masse commune,
- une première diode (D1) ayant une anode et une cathode, l'anode de la première diode (D1) étant raccordée au second pôle de la source de tension (V1),
- un condensateur de mesure (C1) ayant une première électrode et une seconde électrode, la première électrode du condensateur de mesure (C1) étant raccordée à la masse commune, la seconde électrode du condensateur de mesure (C1) étant raccordée à la cathode de la première diode (D1),
- un convertisseur d'impédance ayant un premier pôle et un second pôle, le premier pôle du convertisseur d'impédance étant raccordé à la cathode de la première diode (D1),
- une seconde diode (D2) ayant une anode et une cathode, l'anode de la seconde diode (D2) étant raccordée au second pôle du convertisseur d'impédance,
- un condensateur de sortie (C2) ayant une première électrode et une seconde électrode, la première électrode du condensateur de sortie (C2) étant raccordée à la masse commune, la seconde électrode du condensateur de sortie (C2) étant raccordée à la cathode de la seconde diode (D2), le condensateur de sortie (C2) délivrant un signal de sortie du circuit,
**caractérisé en ce que** le convertisseur d'impédance est un transistor pnp (T1), un émetteur du transistor pnp (T1) formant le premier pôle du convertisseur d'impédance, un collecteur du transistor pnp formant le second pôle du convertisseur d'impédance.

2. Circuit selon la revendication 1, dans lequel une base du transistor pnp (T1) est raccordée au second pôle de la source de tension (V1) par l'intermédiaire d'une première résistance (R1).

3. Circuit selon la revendication 2, dans lequel la première résistance (R1) a une résistance comprise entre 0,5 MOhm et 1,5 MOhm, en particulier 1 MOhm.

4. Circuit selon l'une des revendications précédentes, dans lequel le signal alternatif est un signal à onde carrée.

5. Circuit selon l'une des revendications précédentes, dans lequel le signal alternatif alterne à une fréquence comprise entre 10 kHz et 40 kHz.

6. Circuit selon l'une des revendications précédentes, dans lequel le condensateur de mesure (C1) est conçu pour faire varier sa capacité en fonction d'une distance ou d'une proximité d'un objet proche, en particulier un doigt d'un utilisateur.

7. Circuit selon l'une des revendications précédentes, comprenant en outre une deuxième résistance (R2) raccordée entre la masse commune et la cathode de la première diode (D1), dans lequel la deuxième résistance (R2) a une résistance comprise entre 4,0 MOhm et 5,4 MOhm, de préférence de 4,7 MOhm.

8. Circuit selon l'une des revendications précédentes, comprenant en outre une troisième résistance (R3) raccordée en parallèle au condensateur de sortie (C2), dans lequel la troisième résistance (R3) a une résistance comprise 400 kOhm et 540 kOhm, de préférence de 470 kOhm.

9. Circuit selon l'une des revendications précédentes, comprenant en outre un circuit de bascule de Schmitt raccordé de façon à détecter le signal de sortie et délivrant un signal de sortie binaire.

10. Commutateur de proximité comprenant un circuit selon l'une des revendications précédentes.

11. Commutateur de proximité selon la revendication 10, dans lequel le circuit ne comporte pas de circuit de bascule de Schmitt, le commutateur de proximité comprenant en outre un dispositif de commande pourvu d'une entrée apte à traiter une bascule de Schmitt raccordée au condensateur de sortie (C2) du circuit.

12. Appareil ménager, en particulier un lave-linge ou un réfrigérateur, comprenant un commutateur de proximité selon l'une des revendications 10 ou 11.
